# EUROPEAN PATENT APPLICATION

(11) **EP 1 933 610 A1**
(43) Date of publication of application: **18.06.2008**
(21) Application number: 06782280.9
(22) Date of filing: 03.08.2006
(51) Int. Cl.: H05K 3/28

(54) **BOARD STRUCTURE AND ELECTRONIC DEVICE**

(30) Priority: 30.08.2005 JP 2005250201
(71) Applicant: MATSUSHITA ELECTRIC INDUSTRIAL CO., LTD., Osaka 571-8501 (JP)
(72) Inventor: ONO, Masahiro c/o Matsushita Electric Ind. Co., Ltd., I.P.R.O.C., Chuo-ku, Osaka 540-6207 (JP); UDA, Yosihiro c/o Matsushita Electric Ind. Co., Ltd., I.P.R.O.C., Chuo-ku, Osaka 540-6207 (JP); YAMAGUCHI, Seiji c/o Matsushita Electric Ind. Co., Ltd., I.P.R.O.C., Chuo-ku, Osaka 540-6207 (JP); SHINCHI, Kazuhiro c/o Matsushita Electric Ind. Co., Ltd., I.P.R.O.C., Chuo-ku, Osaka 540-6207 (JP); TOMEKAWA, Satoru c/o Matsushita Electric Ind. Co., Ltd., I.P.R.O.C., Chuo-ku, Osaka 540-6207 (JP)
(74) Representative: Grünecker, Kinkeldey, Stockmair & Schwanhäusser Anwaltssozietät
(86) International application number: PCT/JP2006/315420
(87) International publication number: WO 2007/026499

(57) **Abstract**

A substrate structure whereby a resin part for coating a plurality of electronic components by one operation is given a shielding property and the mounting strength of electronic components with respect to the substrate is secured and an electronic device including the substrate structure are provided.

A substrate structure 10 includes a substrate 11, a plurality of electronic components 12 mounted along the substrate 11, and a resin part 13 coating each electronic component 12 with a resin 18 while kept in close contact with the substrate 11. The substrate structure 10 includes a frame body 15 surrounding each electronic component 12 while kept in close contact with the substrate 11 and a lid part 17 closing an opening 16 in the frame body 15, and a resin 18 is filled inside the frame body 15.

## Description

### Technical Field

The present invention relates to a substrate structure in which a plurality of electronic components are mounted along a substrate, each of the electronic components coated with a resin part, and the resin part kept in close contact with the substrate, and an electronic device including the substrate structure.

### Background Art

In the related art, a substrate structure has been widely known where electronic components are coated with a resin part in order to waterproof the electronic components mounted on a substrate.
A resin used in the substrate structure is often a thermoplastic resin or a gel-shaped silicon resin for example. Such resins are known to have a relatively low elastic modulus after solidification.
Thus, such a substrate structure has a problem that a solidified resin cannot withstand impact such as a drop test, making it difficult to provide the mounting strength of electronic components on a substrate.

A reinforced IC package structure have been proposed that covers an IC package mounted on a motherboard by way of a reinforcing frame including a side face part and an upper face part and that fills a resin into the reinforcing frame (refer to Patent Reference 1).

Patent Reference 1 describes a technique to firmly fix a reinforcing frame and an IC package to a motherboard only by injecting a minimum amount of resin into an appropriate part of the reinforcing frame.
Patent Reference 1: Japanese Patent No.3241669

### Disclosure of the Invention

### Problems that the Invention is to Solve

An electronic component that is requested an electric shielding property is known as an electronic component mounted on a substrate.
However, Patent Reference 1 described above cannot offer a sufficient shielding property since the reinforcing frame includes a plurality of notches.

In Patent Reference 1, a resin is filled into the reinforcing frame from the notches thereof. The reinforcing frame acts as an obstruct in this process and the resulting reinforcing effect is equivalent to that obtained by applying underfill on electronic components, which could lead to insufficient mounting strength of electronic components with respect to a substrate.

The invention has been accomplished to solve the related art problems. An object of the invention is to provide a substrate structure whereby a resin part for coating a plurality of electronic components by one operation is given a shielding property and the mounting strength of electronic components with respect to the substrate is secured and an electronic device including the substrate structure.

### Means for Solving the Problems

The invention provides a substrate structure including a substrate, a plurality of electronic components mounted on the substrate, and a resin part covering each of the electronic components with a resin and coming into contact with the substrate, the substrate structure further including a frame body surrounding each of the electronic components and mounted on the substrate and a lid part closing an opening in the frame body, characterized in that the resin is filled inside the frame body.

The substrate structure, with the lid part closing the opening in the frame body, provides the interior of the frame body as an enclosed space by way of the frame body and the lid part. Then a resin is filled inside the frame body.
This improves the mounting strength of electronic components with respect to a substrate compared with the related art.
For example, a frame body and a lid part made of a metal may be used. Or, a metallic filler to offer a shielding property may be added to a resin. Such approaches give the resin part coating a plurality of electronic components a sufficient shielding property.

The invention provides a substrate structure characterized in that a rib is arranged on the peripheral part of the lid part and that the rib and the frame body overlap each other.

By providing a rib on the peripheral part of the lid and overlapping the rib and the frame body, it is made possible to suppress a gap between the lid part and the frame body, thus providing a reliable shielding property.

The invention provides a substrate structure including a substrate, a plurality of electronic components mounted on the substrate, and a resin part covering each of the electronic components with a resin and coming into contact with the substrate, the substrate structure further including a frame body surrounding each of the electronic components and mounted on the substrate and a lid part closing an opening in the frame body, characterized in that a dielectric filler is contained in the resin and that the resin is filled inside the frame body.

By adding a dielectric filler or a metallic filler to a resin and filling the resin inside the frame body, the resin part covering a plurality of electronic components is given a shielding property.

The invention provides a substrate structure including a substrate, a plurality of electronic components mounted on the substrate, and a resin part covering each of the electronic components with a resin and coming into contact with the substrate, the substrate structure further including a frame body surrounding each of the electronic components and mounted on the substrate and a lid part closing an opening in the frame body, characterized in that the resin is filled inside the frame body and that wiring is arranged on the surface of the resin.

The resin is filled inside the frame body and wiring is arranged as a lid body on the surface of the resin. This makes it possible to face wiring to the opening in the frame body, thus providing a shielding property for a plurality of electronic components with the wiring.
Further, by using wiring as a lid part, it is possible to reduce the thickness dimension of the lid part and provide a low-profile substrate structure.

The invention provides an electronic device including the substrate structure described above.

### Advantage of the Invention

The invention provides advantages that a shielding property is given to a resin part for coating a plurality of electronic components by one operation by providing the interior of the frame body as an enclosed space by way of the frame body and the lid part and filling a resin inside the frame body and that the mounting strength of electronic components with respect to a substrate is provided.

### Brief Description of the Drawings

Fig. 1 is a cross-sectional view of a substrate structure according to a first embodiment of the invention.
Fig. 2 is an exploded perspective view of a substrate structure according to the first embodiment.
Fig. 3 illustrates an example where a die is clamped in the manufacturing process of a substrate structure according to the first embodiment.
Fig. 4 illustrates an example where a molten resin is injected in the manufacturing process of a substrate structure according to the first embodiment.
Fig. 5 is a cross-sectional view of a substrate structure according to a second embodiment of the invention.
Fig. 6 is a cross-sectional view of a substrate structure according to a third embodiment of the invention.
Fig. 7 is a cross-sectional view of a substrate structure according to a third embodiment of the invention.
Fig. 8 illustrates an example where a molten resin is injected by a predetermined amount in the manufacturing process of a substrate structure according to the third embodiment.
Fig. 9 illustrates an example where a molten resin is built up on a lid part in the manufacturing process of a substrate structure according to the third embodiment.
Fig. 10 illustrates an example where a substrate structure is set in a die in the manufacturing process of a substrate structure according to the third embodiment.
Fig. 11 illustrates an example where amolten resin is injected by clamping a die in the manufacturing process of a substrate structure according to the third embodiment.
Fig. 12A through 12C illustrate the manufacturing process of a substrate structure according to a fourth embodiment of the invention.
Fig. 13 is a cross-sectional view of a substrate structure according to a fifth embodiment of the invention.
Fig. 14 is an exploded perspective view of a substrate structure according to the fifth embodiment.
Fig. 15 illustrates an example where a die is clamped in the manufacturing process of a substrate structure according to the fifth embodiment.
Fig. 16 illustrates an example where a molten resin is injected in the manufacturing process of a substrate structure according to the fifth embodiment.
Fig. 17 is a cross-sectional view of a substrate structure according to a sixth embodiment of the invention.
Fig. 18 is an exploded perspective view of a substrate structure according to the sixth embodiment.
Fig. 19 illustrates an example where a die is clamped in the manufacturing process of a substrate structure according to the sixth embodiment.
Fig. 20 illustrates an example where a molten resin is injected in the manufacturing process of a substrate structure according to the sixth embodiment.
Fig. 21 illustrates an example where a lid part is put in the manufacturing process of a substrate structure according to the sixth embodiment.
Fig. 22 is a cross-sectional view of a substrate structure according to a seventh embodiment of the invention.

### Description of Reference Numerals and Signs

10, 40, 50, 60, 70, 80, 90: Substrate structure
11: Substrate
12: Electronic component
13: Resin part
15: Frame body
16: Opening
17, 71, 81: Lid part
18, 41: Resin
18C: Surface of resin
42: Filler
71A: Linear conductor
84: Rib

### Best Mode for Carrying Out the Invention

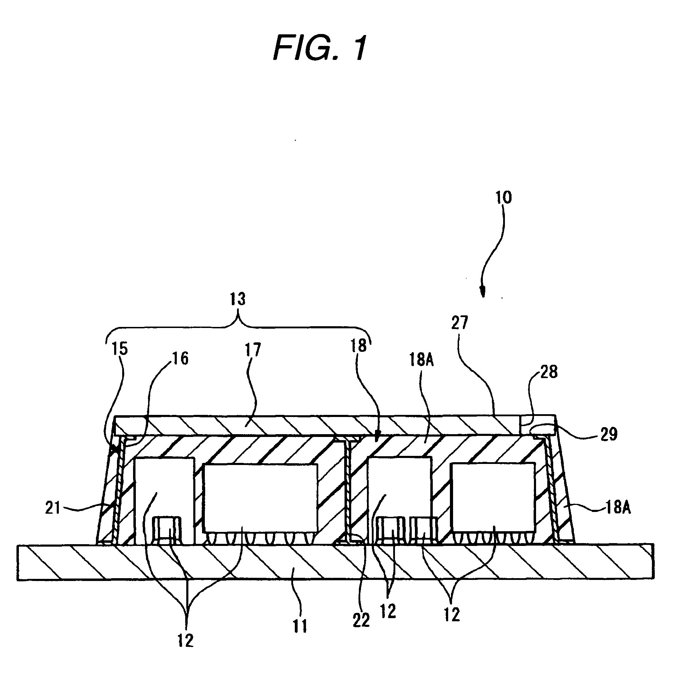

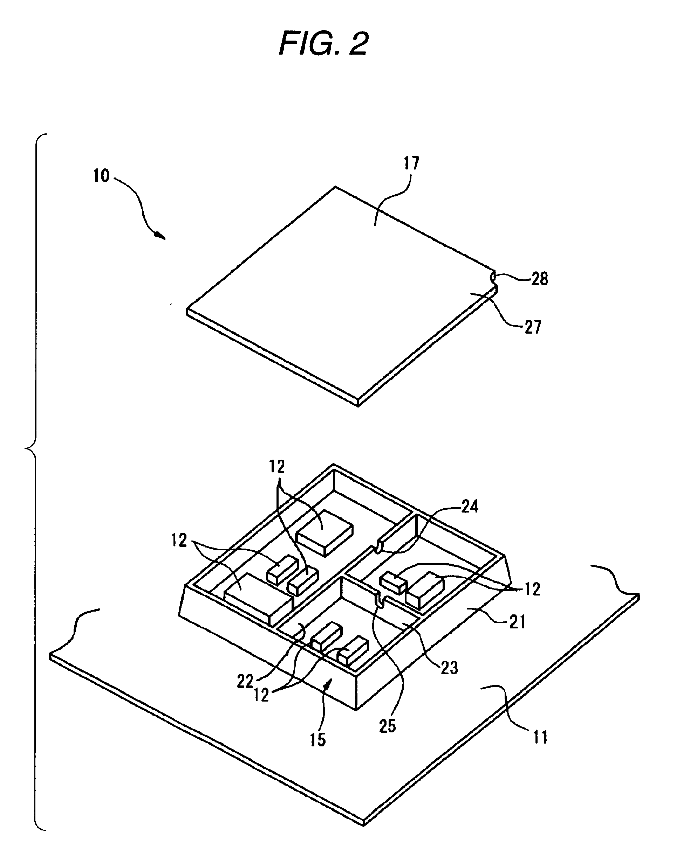

A substrate structure according to embodiments of the invention will be described referring to figures.
As shown in Figs. 1 and 2, a substrate structure 10 according to a first embodiment includes a substrate 11, a plurality of electronic components 12 mounted along the substrate 11, and a resin part 13 coating each electronic component 12 with a resin while kept in close contact with the substrate 11. The substrate structure 10 is accommodated in the enclosure of an electronic device such as a cell phone.
The resin part 13 includes a frame body 15 surrounding the electronic components 12 while kept in close contact with the substrate 11 and a lid part 17 closing an opening 16 in the frame body 15, and a resin 18 is filled inside the frame body 15.

The frame body 15 has an outer frame 21 formed in an almost rectangular shape. The lower part of the outer frame 21 is kept in close contact with the substrate 11 and the upper part thereof has an opening. First and second parting frame bodies 22, 23 are arranged inside the outer frame 21. The first and second parting frame bodies 22, 23 have their lower parts kept in close contact with the substrate 11.

The upper part of the outer frame 21 and the upper parts of the first and second parting frame bodies 22, 23 have their heights predetermined so that these upper parts are flush with each other.
In the upper part of the first parting frame body 22 is formed a first communication groove 24 communicating both side spaces of the first parting frame body 22. In the upper part of the second parting frame body 23 is formed a second communication groove 25 communicating both side spaces of the first parting frame body 23.

The opening 16 in the frame body 15 is closed by the lid part 17. The lid part 17 is an almost rectangular plate formed one size larger than the upper part of the outer frame 21.
The lid body 15 has a notch 28 at a corner part 27. The notch 28 and the outer frame 21 form a communication hole 29 when the opening 16 in the frame body 15 is closed with the lid part 17. The first communication groove 24 and the lid body 15 form a first communication hole. The second communication groove 25 and the lid body 15 form a second communication hole.
By the above configuration, the interior of the frame body 15 is communicated with the exterior of the frame body 15 via the communication hole 29.

Inside the frame body 15 is filled a resin 18. To be more precise, among the resin 18, most of the resin 18A is filled inside the outer frame 21 and remaining small amount of resin 18B is provided along the exterior of the outer frame 21.

The substrate structure 10 according to the first embodiment includes a lid part 17 closing the opening 16 in the frame body 15 and thus provides the interior of the frame body 15 as an enclosed space by way of the frame body 15 and the lid part 17. The substrate structure 10 fills the resin 18 inside the frame body 15.
Accordingly, the mounting strength of a plurality of electronic components 12 with respect to the substrate 11 is improved as compared with the related art.

By using a metallic frame body 15 and a metallic lid part 17 or adding a metallic filler to provide a shielding property to the resin 18, the resin 18 coating a plurality of electronic components 12 is given a shielding property.

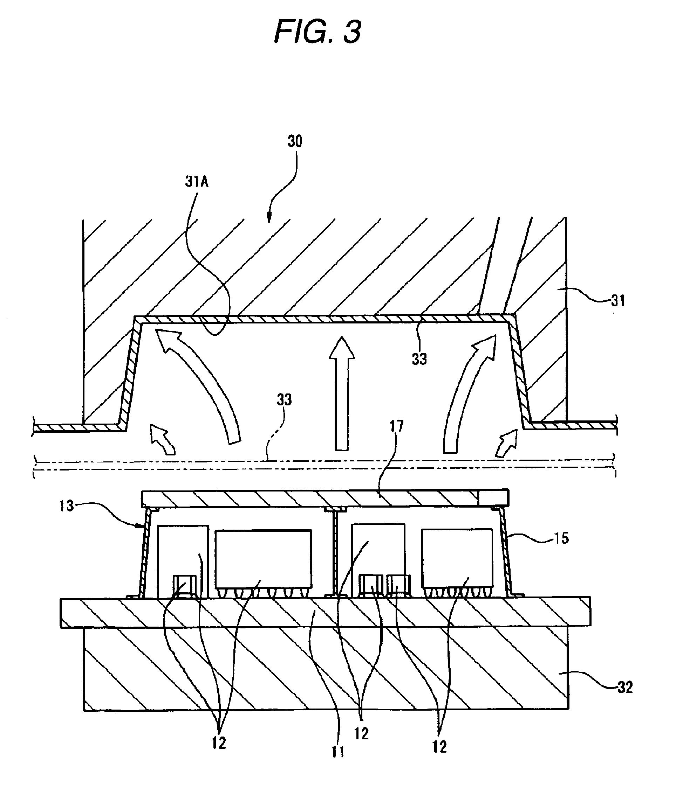

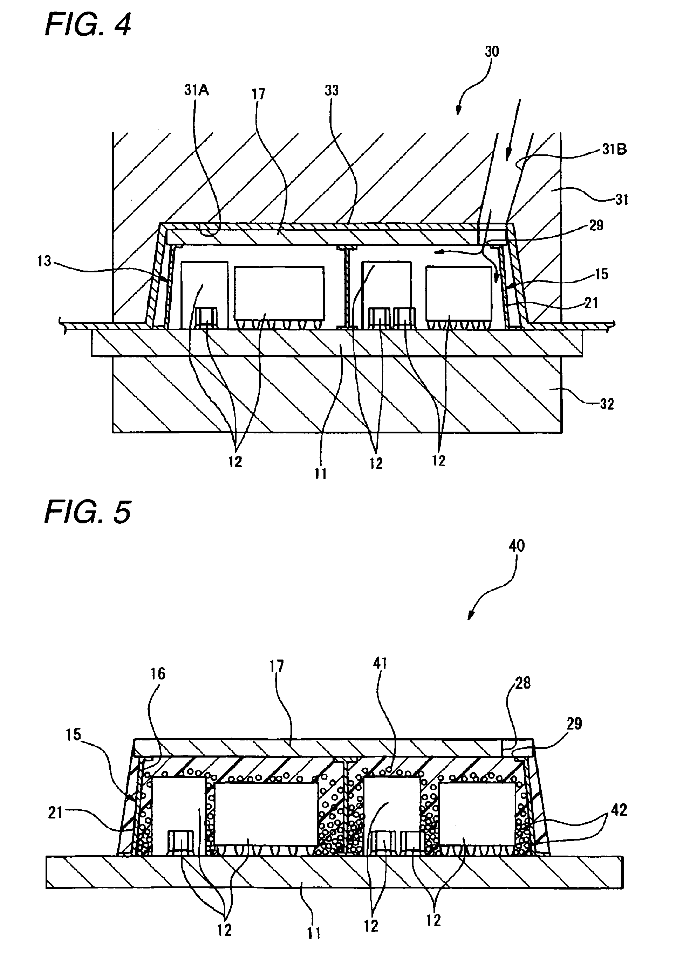

A process of manufacturing a substrate structure 10 according to the first embodiment will be described based on Figs. 3 and 4.
As shown in Fig. 3, a plurality of electronic components 12 are mounted on a substrate 11 and a frame body 15 and a lid part 17 in the resin part 13 are arranged.
In this state, the substrate structure 10 is arranged between a pair of dies 30, that is, between an upper die 31 and a lower die 32. A release film 33 is arranged between the upper die 31 and the lid part 17.

The release film 33 is arranged between the upper die 31 and the lid part 17 in a state unwound from a roll-wound state.
The release film 33 thus arranged is vacuum sucked onto the molding face 31A of the upper die 31. The die 30 is clamped in this state.

As shown in Fig. 4, a molten resin for a resin 18 shown in Fig. 1 is injected from the gate 31B of the upper die 31 into the interior of the outer frame 21 and then exterior thereof via a communication hole 29.
The molten resin is solidified to obtain a resin 18.
After the molten resin is solidified, the die 30 is opened.
This completes the manufacturing process of the substrate structure 10.

The second to seventh embodiments will be described based on Figs. 5 to 22. In the second to seventh embodiments, a same or similar member as that in the substrate structure 10 according to the first embodiment is given a same sign and the corresponding description is omitted.

### Second embodiment

A substrate structure 40 according to the second embodiment shown in Fig. 5 includes a resin 41 instead of the resin 18 in the first embodiment. The other configuration is similar to the substrate structure 10 according to the first embodiment.
The resin 41 is obtained through injection molding of a resin to which a filler 42 is added. The resin 41 is filled inside a frame body 15.
The filler 42 is for example a silica filler (SiO₂)and its particle diameter is preferably an average of 8 µm or larger or a maximum of 40 µm or smaller.

In case a metallic filler such as ferrite particles is added to the resin 41 for filler 42, the resin 41 coating a plurality of electronic components 12 is given a shielding property when filled inside the frame body 15.
In particular, the filler 42 precipitates by dead weight in the process of injection molding of the resin 41. The filler 42 is collected on the periphery of the electronic components 12 thus forming a high-concentration shielding layer.
The substrate structure 40 according to the second embodiment provides the same advantage as that of the substrate structure 10 according to the first embodiment.

### Variation of second embodiment

While the filler 42 precipitates by dead weight in the example related to the substrate structure 40 according to the second embodiment, the filler 42 may be collected on the periphery of the electronic components 12 by the use of centrifugal force in the process of injection molding of the resin 41.
The use of centrifugal force efficiently collects the filler 42 on the periphery of the electronic components 12 without taking time and obtains a higher-concentration shielding layer as well as improves the productivity.

### Third embodiment

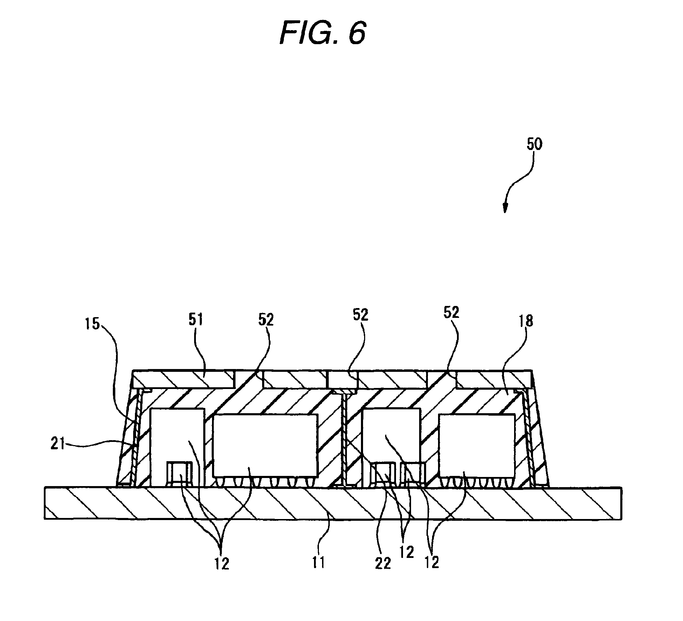

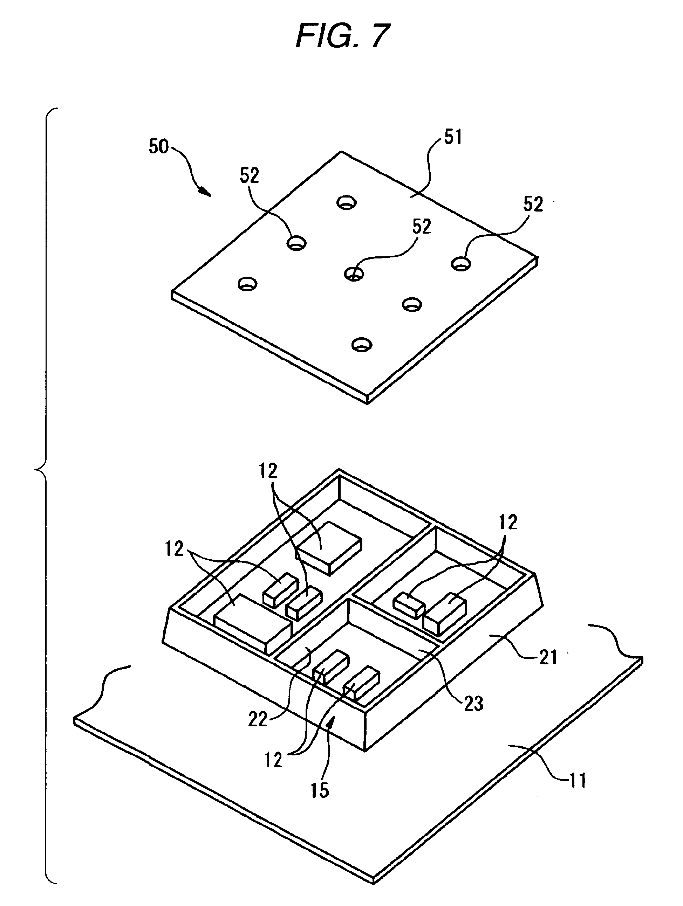

A substrate structure 50 according to the third embodiment shown in Figs. 6 and 7 includes a lid part 51 instead of the lid part 17 in the first embodiment. The other configuration is similar to the substrate structure 10 according to the first embodiment.
The lid part 51 has a plurality of injection ports 52 formed therein. The plurality of injection ports 52 communicate to the interior of the outer frame 21 (that is, interior of the frame body 15).
This communicates the interior of the frame body 15 with the exterior of the frame body 15 via the plurality of injection ports 52.

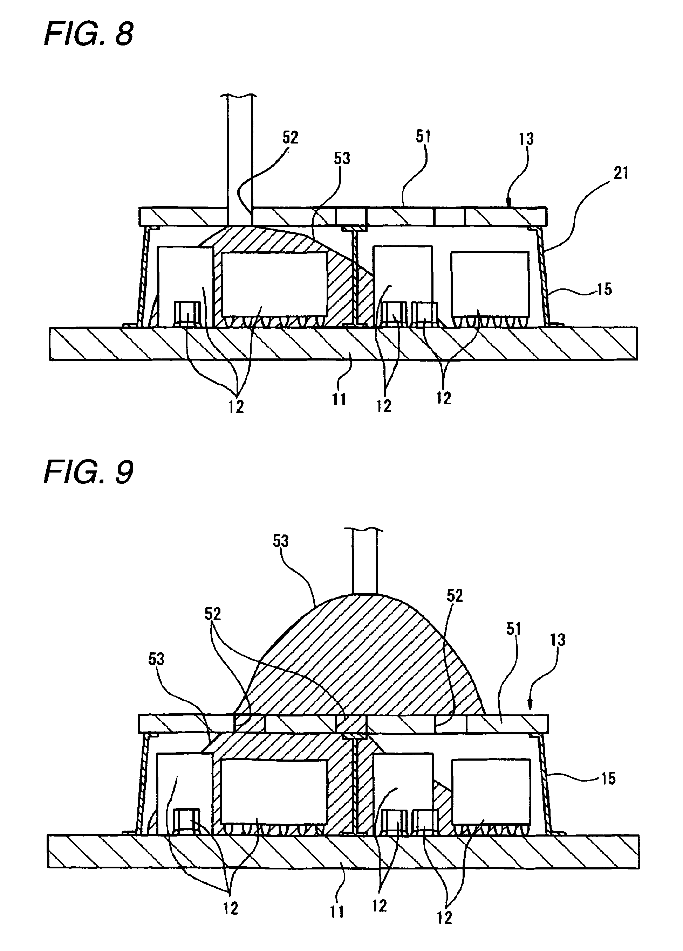

A process of manufacturing a substrate structure 50 according to the third embodiment will be described based on Figs. 8 to 11.
As shown in Fig. 8, a plurality of electronic components 12 are mounted on a substrate 11 and a frame body 15 and a lid part 51 in the resin part 13 are arranged. In this state, a molten resin 53 for the resin 18 shown in Fig. 6 is supplied from above the lid part 51 and injected into the interior of the frame body 15 from the injection ports 52 in the lid part 51.
Injection of the molten resin 53 is stopped before the molten resin 53 is completely filled inside the frame body 15. That is, injection of the molten resin 53 is stopped in a state where the amount of injection into the interior of the frame body 15 is as shown in Fig. 8.
As shown in Fig. 9, the molten resin 53 is built up on the upper part of the lid part 51.

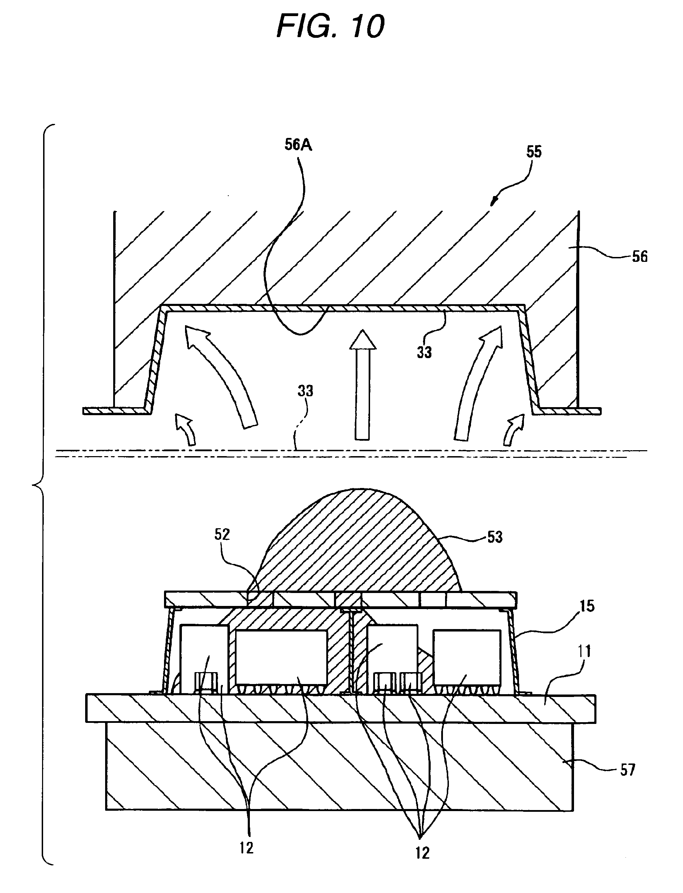

In this state, as shown in Fig. 10, the substrate structure 50 is arranged between a pair of dies 55, that is, between an upper die 56 and a lower die 57. A release film 33 is arranged between the upper die 56 and the molten resin 53.
The release film 33 thus arranged is vacuum sucked onto the molding face 56A of the upper die 56. The die 55 is clamped in this state.

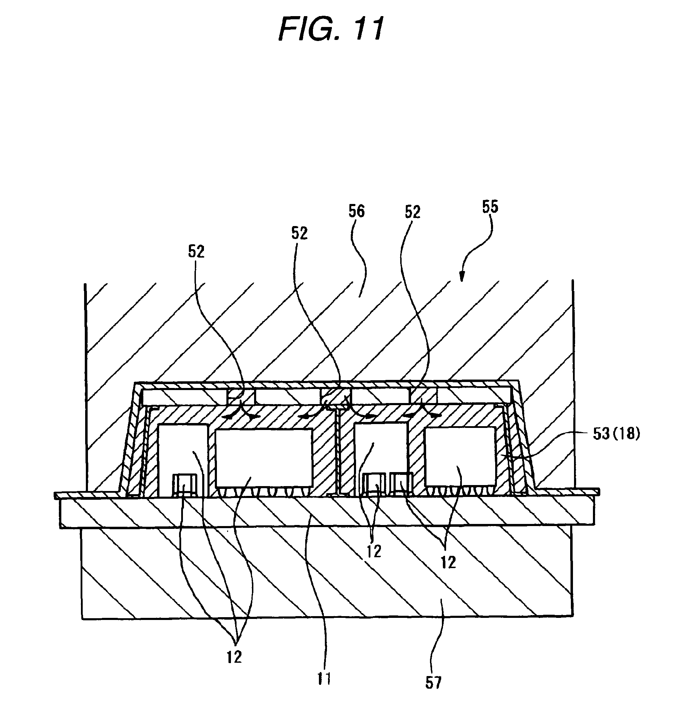

As shown in Fig. 11, the molten resin 53 built up on the upper part of the lid part 51 is injected into the interior of the frame body 15 from the plurality of injection ports 52 by clamping the die 55. The molten resin 53 is filled inside the frame body 15.
The molten resin 53 is solidified to obtain a resin 18. After the molten resin 53 is solidified, the die 55 is opened.
Thus, the manufacturing process of the substrate structure 50 is completed.

With the substrate structure 50 according to the third embodiment, the molten resin 53 built up on the lid part 51 is injected into the interior of the frame body 15 by clamping the die 55. Accordingly, the lid part 51 is reliably prevented from floating from the upper part of the frame body 15 when the molten resin 53 is injected into the interior of the frame body 15 thus enhancing the contact between the frame body 15 and the lid part 51.
The substrate structure 50 according to the third embodiment provides the same advantage as that of the substrate structure 10 according to the first embodiment.

### Fourth embodiment

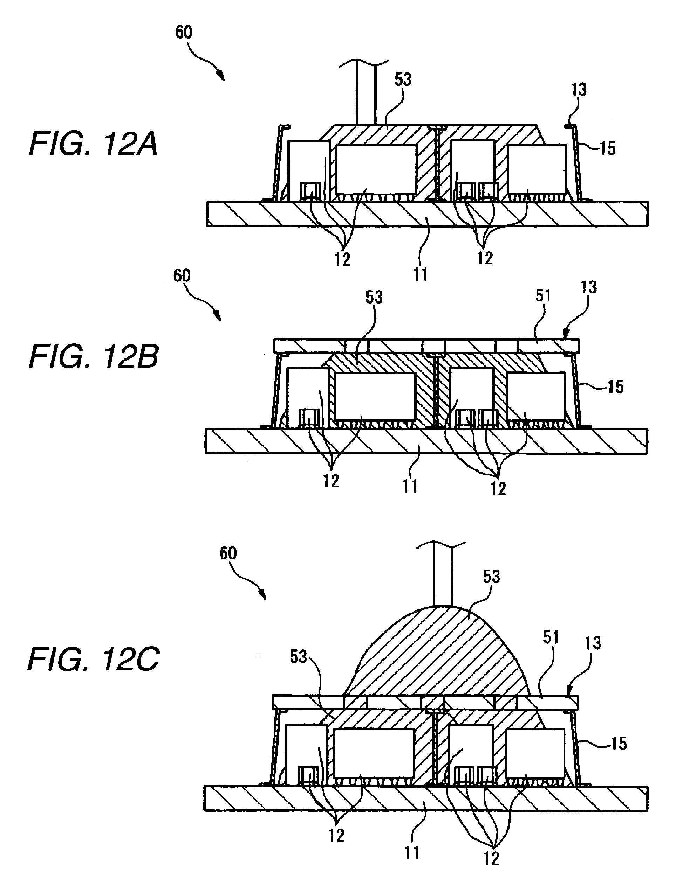

In the manufacturing method of a substrate structure 60 according to the fourth embodiment shown in Figs. 12A to 12C, the molten resin 53 is injected into the interior of the frame body 15 before the lid part 51 is arranged on the frame body 15, unlike the manufacturing method of the substrate structure 50 according, to the third embodiment. The configuration of the substrate structure 60 according to the fourth embodiment is the same as that of the substrate structure 50 according to the third embodiment.

A process of manufacturing a substrate structure 60 according to the fourth embodiment will be described based on Figs. 12A to 12C.
As shown in Fig. 12A, a plurality of electronic components 12 are mounted on a substrate 11 and a frame body 15 in the resin part 13 is arranged. In this state, a molten resin 53 for the resin 18 shown in Fig. 6 is supplied from above the frame body 15 and injected into the interior of the frame body 15.
Injection of the molten resin 53 is stopped before the molten resin 53 is completely filled inside the frame body 15. That is, injection of the molten resin 53 is stopped in a state where the amount of injection into the interior of the frame body 15 is as shown in Fig. 12A.

As shown in Fig. 12B, a lid part 51 is arranged on the upper part of the frame body 15. In this state, the molten resin 53 is built up on the upper part of the lid part 51.

In this state, as shown in Fig. 10, the substrate structure 60 is arranged between a pair of dies 55, that is, between an upper die 56 and a lower die 57. A release film 33 is arranged between the upper die 56 and the molten resin 53.
The release film 33 thus arranged is vacuum sucked onto the molding face 56A of the upper die 56. The die 55 is clamped in this state.

As shown in Fig. 11, the molten resin 53 built up on the upper part of the lid part 51 is injected into the interior of the frame body 15 from the plurality of injection ports 52 by clamping the die 55. The molten resin 53 is filled inside the frame body 15.
The molten resin 53 is solidified to obtain a resin 18. After the molten resin 53 is solidified, the die 55 is opened.
Thus, the manufacturing process of the substrate structure 60 is completed.

With the substrate structure 60 according to the fourth embodiment, the molten resin 53 is injected into the frame body 15 before the lid part 51 is arranged on the frame body 15. Accordingly, the lid part 51 is reliably prevented from floating from the upper part of the frame body 15 thus enhancing the contact between the frame body 15 and the lid part 51.
The substrate structure 60 according to the fourth embodiment provides the same advantage as that of the substrate structure 50 according to the third embodiment.

### Fifth embodiment

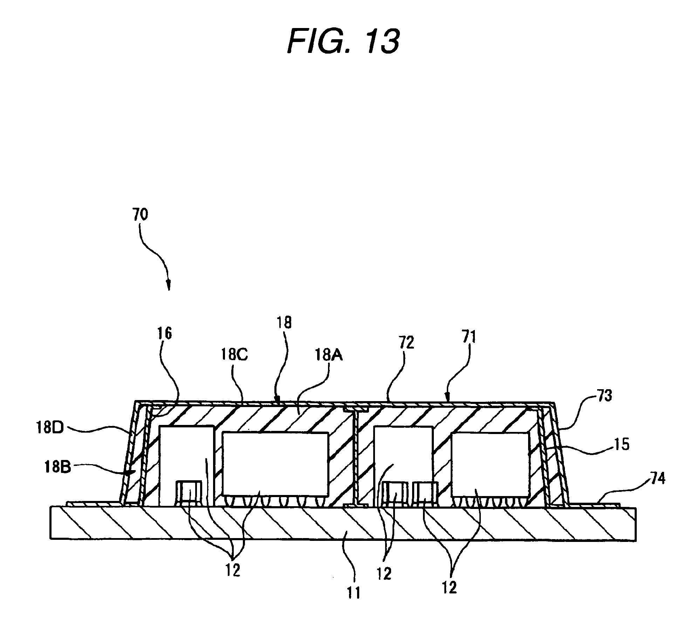

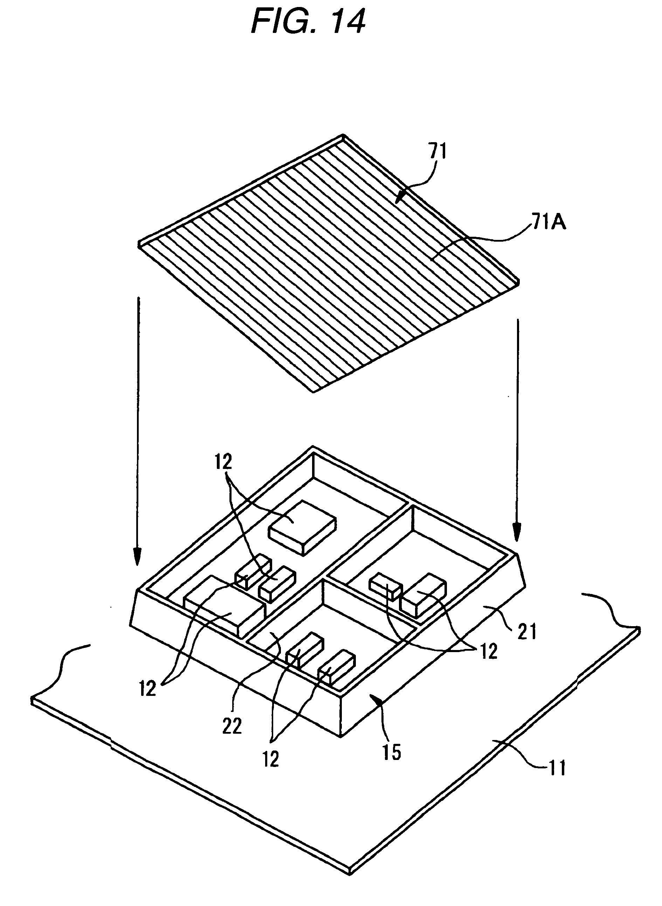

A substrate structure 70 according to the fifth embodiment shown in Figs. 13 and 14 includes a lid part 71 instead of the lid part 17 in the first embodiment. The other configuration is similar to the substrate structure 10 according to the first embodiment. The lid part 71 is wiring in which a plurality of linear conductors 71A are routed in parallel in the shape of a sheet. The lid part 71 is made by transfer of the wiring routed on the surface of a release film to the top surface (surface) 18C of the resin 18.

The lid part 71 includes a flat top part 72, a side wall 73 arranged at the outer shape part of the top part 72, and a base part 74 arranged at the lower part of the side wall 73.
The top part 72 is arranged to face the opening 16 in the frame body 15 and transferred to the top surface 18C of the resin 18A filled inside the frame body 15.
The side wall 73 is transferred to the surface 18D of the resin 18B. The resin 18B is arranged outside the outer frame 21.

The base part 74 is in contact with a substrate 11. The base part is in contact with the substrate 11 so that the frame body 15 need not be a metallic member.
In case the base part is not in contact with the substrate 11, the frame body 15 must be a metallic member.

The lid part 71 maybe wiring in which a single linear conductor is routed in a meandering manner instead of the wiring in which a plurality of linear conductors are routed in parallel.

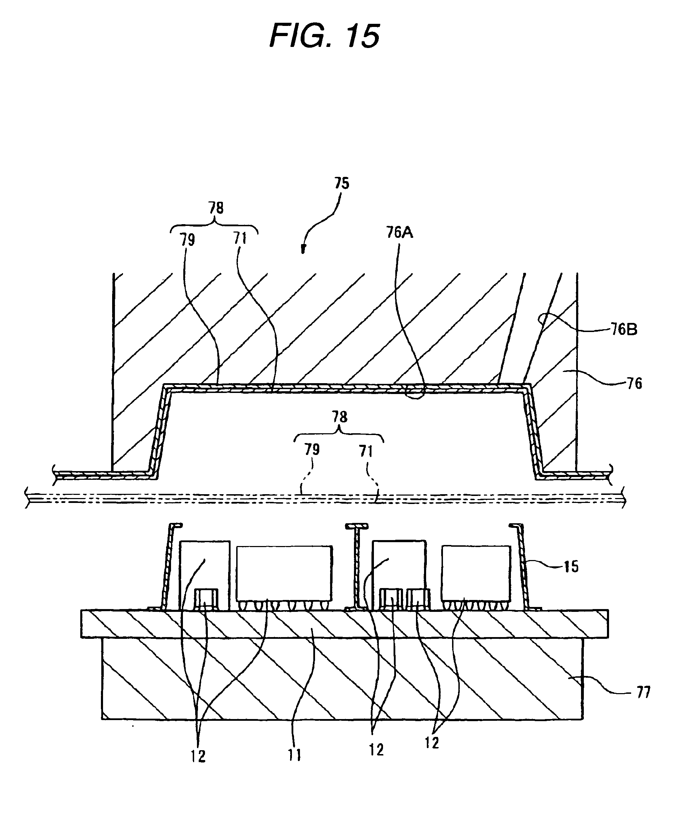

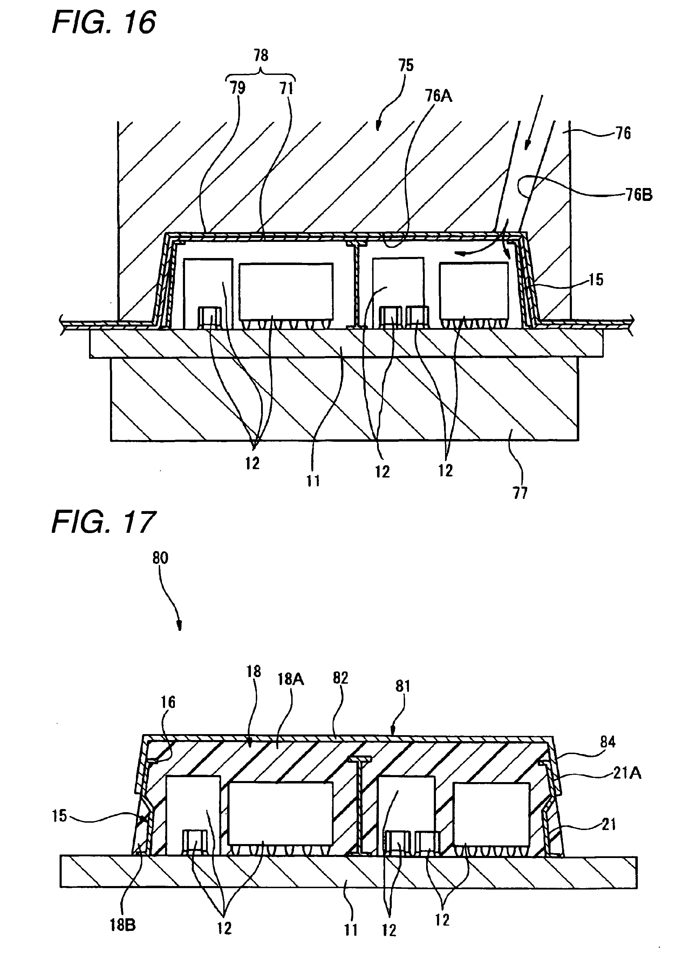

Next, a process of manufacturing a substrate structure 70 according to the fifth embodiment will be described based on Figs. 15 and 16.
As shown in Fig. 15, a plurality of electronic components 12 are mounted on a substrate 11 and a frame body 15 is arranged. In this state, the substrate structure 70 is arranged between a pair of dies 75, that is, between an upper die 76 and a lower die 77. A wiring sheet 78 is arranged between the upper die 76 and the frame body 15.
The wiring sheet 78 is made of a release sheet 79 and a lid part 71 in the shape of wiring arranged on the bottom surface of the release sheet 79.
The wiring sheet 78 is vacuum sucked onto the molding face 76A of the upper die 76. The die 75 is clamped in this state.

As shown in Fig. 16, after the die 75 is clamped, a molten resin for a resin 18 shown in Fig. 13 is injected from the gate 76B of the upper die 76 into the interior of the frame body 15. The molten resin is filled inside the frame body 15.
The molten resin is solidified to obtain a resin 18. After the molten resin is solidified, the die 75 is opened.
This completes the manufacturing process of the substrate structure 70.

With the substrate structure 70 according to the fifth embodiment, a resin is filled into the interior of the frame body and wiring is arranged on the surface of the resin. This makes it possible to face the wiring to the opening in the frame body thus allowing the wiring to provide a shielding property for a plurality of electronic components.
With the substrate structure 70 according to the fifth embodiment, it is possible to reduce the thickness dimension of the lid part 71 by using wiring as the lid part 71, thus providing a low-profile substrate structure 70.
Moreover, the substrate structure 70 according to the fifth embodiment provides the same advantage as that of the substrate structure 10 according to the first embodiment.

### Sixth embodiment

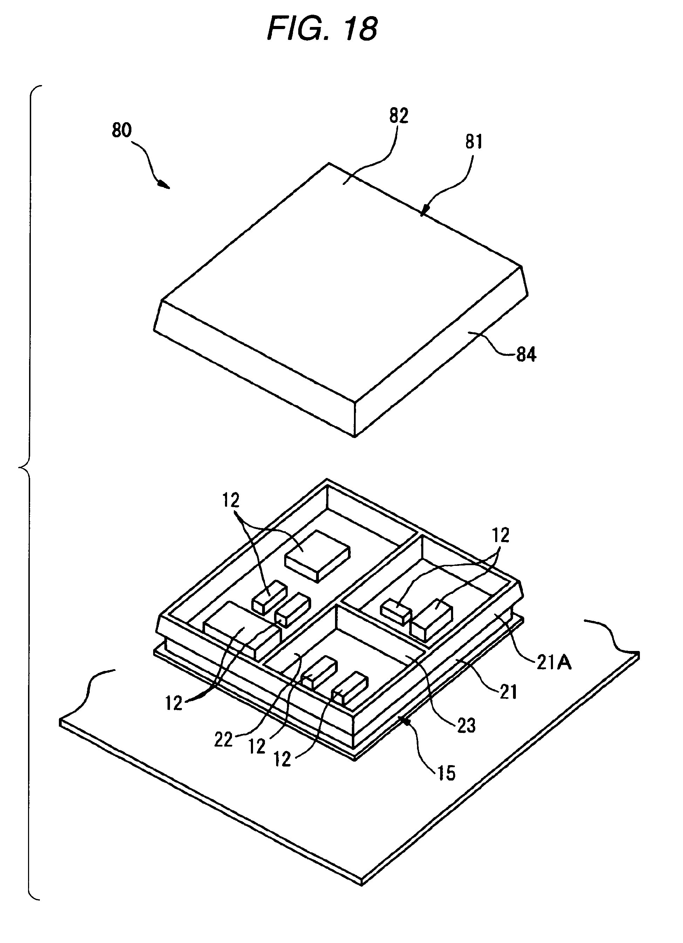

A substrate structure 80 according to the sixth embodiment shown in Figs. 17 and 18 includes a lid part 81 instead of the lid part 17 in the first embodiment. The other configuration is similar to the substrate structure 10 according to the first embodiment. The lid part 81 includes a top part 82 facing the opening 16 with a rib 84 arranged on the peripheral part 83 of the top part 82.

The rib 84 is formed one size larger than the outer frame 21 so that the rib 84 will overlap the upper part 21A of the outer frame 21 constituting the frame body 15.
The rib 84 is formed in a tapered shape in a gradually opening manner. The upper part 21A of the outer frame 21 is also formed in a tapered shape. Accordingly, the rib 84 is allowed to come into contact with the upper part 21A of the outer frame 21 thus closing the opening 16 with the lid part 81.

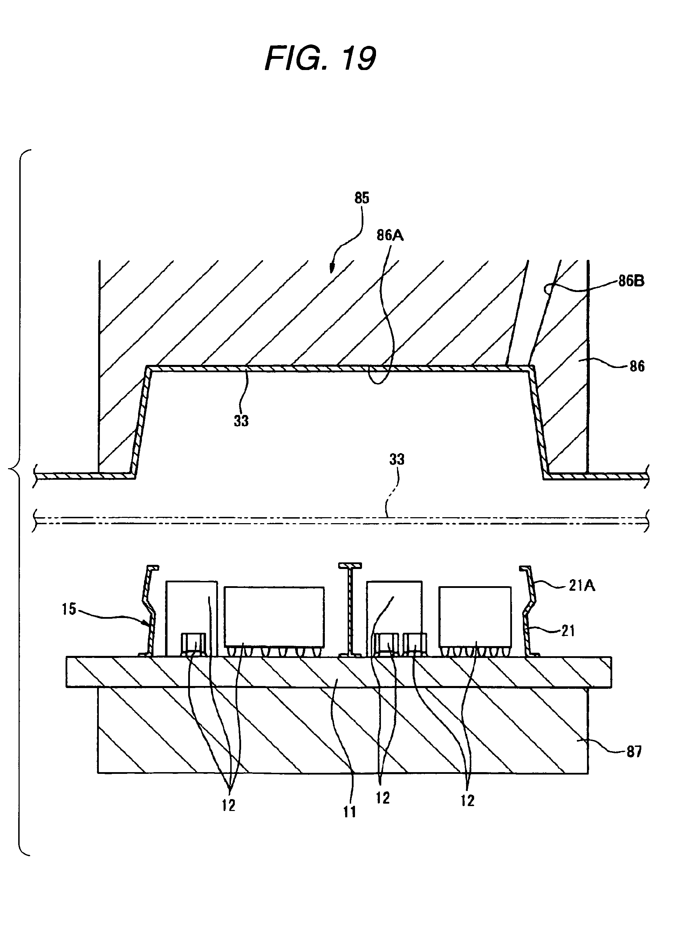

Next, a process of manufacturing a substrate structure 80 according to the sixth embodiment will be described based on Figs. 19 to 21.
As shown in Fig. 19, a plurality of electronic components 12 are mounted on a substrate 11 and a frame body 15 is arranged.
In this state, the substrate structure 80 is arranged between a pair of dies 85, that is, between an upper die 86 and a lower die 87. A release film 33 is arranged between the upper die 86 and the frame body 15.
The release film 33 is vacuum sucked onto the molding face 86A of the upper die 86. The die 85 is clamped in this state.

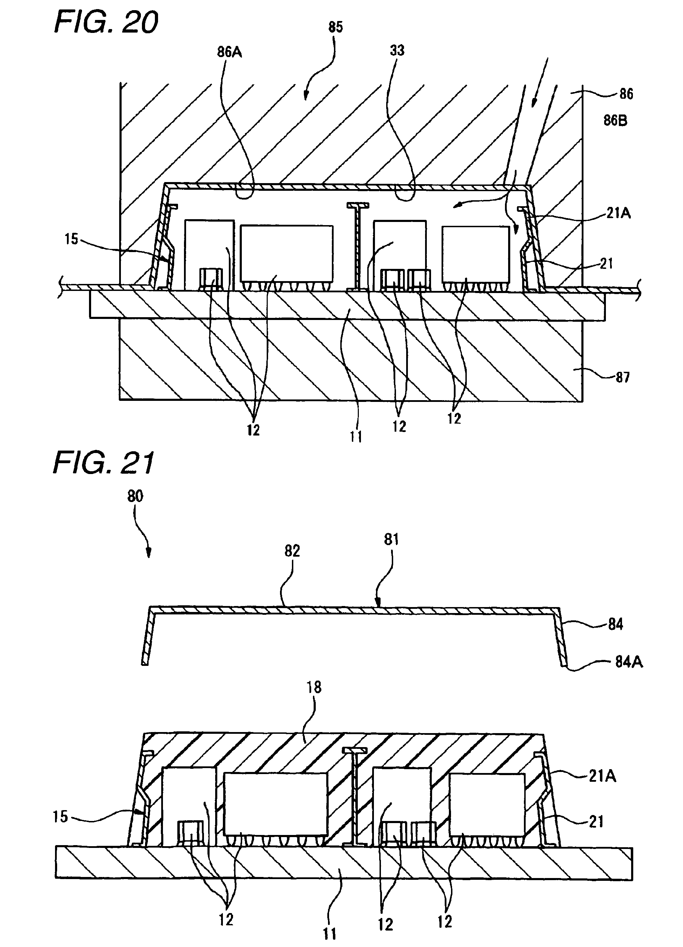

As shown in Fig. 20, after the die 85 is clamped, a molten resin for a resin 18 shown in Fig. 17 is injected from the gate 86B of the upper die 86 into the interior of the frame body 15. The molten resin is filled inside the frame body 15.
The molten resin is solidified to obtain a resin 18. After the molten resin is solidified, the die 85 is opened.

In this state, the upper part 21A of the outer frame 21 is exposed. A lid part 81 is put on the exposed upper part 21A of the outer frame 21.
The rib 84 is formed in a tapered shape in a gradually opening manner. The end edge 84A of the rib 84 is also formed in a tapered shape in a gradually opening manner.

This readily fits the rib 84 onto the upper part 21A of the outer frame 21 allowing the lid part 81 to be put thereon.
By putting the lid part 81 on the upper part 21A of the outer frame 21, the upper part 21A of the outer frame 21 and the rib 84 overlap each other in a contact state.
This completes the manufacturing process of the substrate structure 80.

With the substrate structure 80 according to the sixth embodiment, the rib 84 is arranged on the peripheral part of the lid part 81 and the rib 81 overlaps the upper part 21A of the outer frame 21. This suppresses a gap between the lid part 81 and the frame body 15, thus providing a reliable shielding property.
The substrate structure 80 according to the seventh embodiment provides the same advantage as that of the substrate structure 10 according to the first embodiment.

### Seventh embodiment

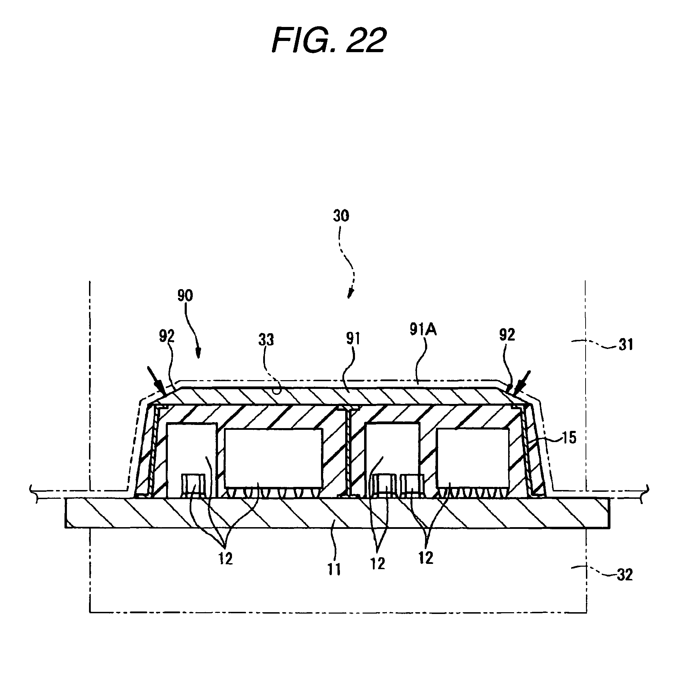

A substrate structure 90 according to the seventh embodiment shown in Fig. 22 includes a lid part 91 instead of the lid part 17 in the first embodiment. The other configuration is similar to the substrate structure 10 according to the first embodiment.
The lid part 91 is made of an edge part 92 formed into an upward tapered shape. The other configuration is similar to the lid part 17 according to the first embodiment.

The edge part 92 of the lid part 91 is formed in a tapered shape so that the pressing force of the upper die is directed in oblique direction when the die 33 is clamped.
The oblique pressing force prevents a molten resin from infiltrating into the side of the surface 91A of the lid part 91 when the molten resin is injected.
This prevents printed letters or marking on the surface 91A of the lid part 91 from being illegible while covered with a resin.

The shape or dimension of each of the resin parts, frame bodies, lid parts, resins and ribs described as examples in the first to seventh embodiments may be changed as required.

This application is based on the Japanese Patent Application No.2005-250201 filed August 30, 2005 and its contents are incorporated herein as a reference.

### Industrial Applicability

This invention is appropriate for application to a substrate structure in which a plurality of electronic components are mounted along a substrate, each of the electronic components coated with a resin part, and the resin part kept in close contact with the substrate, and an electronic device including the substrate structure.

## Claims

1. A substrate structure including a substrate, a plurality of electronic components mounted on said substrate, and a resin part covering each of said electronic components with a resin and coming into contact with said substrate,
said substrate structure further including a frame body surrounding each of said electronic components and mounted on said substrate and a. lid part closing an opening in said frame body,
wherein said resin is filled inside said frame body.

2. The substrate structure according to claim 1, wherein
a rib is arranged on the peripheral part of said lid part and that said rib and said frame body overlap each other.

3. A substrate structure including a substrate, a plurality of electronic components mounted on said substrate, and a resin part covering each of said electronic components with a resin and coming into contact with said substrate,
said substrate structure further including a frame body surrounding each of said electronic components and mounted on said substrate and a lid part closing an opening in said frame body,
wherein a dielectric filler is contained in said resin and that said resin is filled inside said frame body.

4. A substrate structure including a substrate, a plurality of electronic components mounted on said substrate, and a resin part covering each of said electronic components with a resin and coming into contact with said substrate,
said substrate structure further including a frame body surrounding each of said electronic components and mounted on said substrate and a lid part closing an opening in said frame body,
wherein said resin is filled inside said frame body and that wiring is arranged on the surface of said resin.

5. An electronic device including the substrate structure according to any one of claims 1 to 4.
